## Europäisches Patentamt

## European Patent Office

## Office européen des brevets

(19)

(11) Veröffentlichungsnummer: **0 216 311**
**B1**

(12) **EUROPÄISCHE PATENTSCHRIFT**

(45) Veröffentlichungstag der Patentschrift:
**15.03.89**

(21) Anmeldenummer: **86112877.5**

(22) Anmeldetag: **18.09.86**

(51) Int. Cl.⁴: **B65D 81/24, B65D 81/18**

(54) Behälter und Verfahren zu seiner Herstellung.

(30) Priorität: **20.09.85 US 778398**
**10.03.86 US 838292**

(43) Veröffentlichungstag der Anmeldung:
**01.04.87 Patentblatt 87/14**

(45) Bekanntmachung des Hinweises auf die Patenterteilung:
**15.03.89 Patentblatt 89/11**

(84) Benannte Vertragsstaaten:
**AT BE CH DE FR GB IT LI LU NL SE**

(56) Entgegenhaltungen:
**DE-A- 2 947 262**
**US-A- 2 766 920**
**US-A- 3 341 102**
**US-A- 4 480 747**

(73) Patentinhaber: **Hans Kolb Wellpappe, Memminger Strasse 25, D-8940 Memmingen(DE)**
Patentinhaber: **Conductive Containers Inc., 425 Huehl Road, Unit 2, Northbrook Illinois 60062(US)**

(72) Erfinder: **Ohlbach, Ralph C., Chicago, Ill, 60015, 417 Green Park(US)**

(74) Vertreter: **Patentanwälte Grünecker, Dr. Kinkeldey, Dr. Stockmair, Dr. Schumann, Jakob, Dr. Bezold, Meister, Hilgers, Dr. Meyer-Plath, Maximilianstrasse 58, D-8000 München 22(DE)**

**Beschreibung**

Die Erfindung betrifft einen Behälter der im Oberbegriff des Patentanspruchs 1 angegebenen Art sowie ein Verfahren zur Herstellung eines solchen Behälters.

Aus der DE-OS 2 947 262 ist ein aus einem ebenen Behälterzuschnitt aus Wellpappe oder einem ähnlich steifen Pappmaterial gefalteter Behälter bekannt, der innen- und außenseitig eine leitfähige Beschichtung in Form einer aufgedruckten, Kohlenstoffpartikel enthaltenden Lösung aufweist. Elektrostatische Ladungen, unabhängig davon, ob sie von außen oder von innen an die Oberflächenbeschichtung herangetragen werden, fangen sich und werden aufgezehrt oder abgeleitet, ohne den oder die zu schützenden Gegenstände im Behälter schädigen zu können. Vor elektromagnetischen oder Radiofrequenz-Feldern vermag der Behälter die untergebrachten Gegenstände jedoch nicht zuverlässig zu schützen.

In der Praxis sind ferner Kartons mit Stülpdeckel bekannt, bei denen die Außenseiten des Kartonunterteils und die Innenseite des Stülpdeckels mit einer aufkaschierten Metallfolie überzogen sind. Die Überzüge schirmen zwar die Gegenstände vor elektromagnetischen oder Radiofrequenz-Feldern ab. Da die Überzüge aber Leiter sind, kann bei ihrer Bewegung in einem hochfrequenten Feld dem Kirchhoff'schen Gesetz zufolge auf dem Überzug eine Spannung oder ein Strom induziert werden. Sobald der Karton unter ungünstigen Bedingungen geöffnet und/oder der Gegenstand herausgenommen wird, können die Spannung oder die Ladung auf dem Überzug die Quelle eines für den Gegenstand schädlichen Funkens oder einer Entladungsspitze sein, da der Überzug wie ein Kondensator wirken kann. Dieses Abschirmungsprinzip ist auch bekannt aus den US-PSen 2 766 920 und 2 899 050, sowie aus einem Artikel aus Publikation ITEM, 1983, mit dem Titel "Shielding-Coating Options in the Eighties".

Der Erfindung liegt die Aufgabe zugrunde, einen Behälter der eingangs genannten Art mit einer verbesserten Schutzwirkung für gegen elektrische Einflüsse empfindliche Gegenstände zu schaffen.

Die gestellte Aufgabe wird erfindungsgemäß mit den im kennzeichnenden Teil des Patentanspruchs 1 angegebenen Merkmalen gelöst.

Bei dieser Ausbildung des Behälters schirmt die Folie den oder die im Behälter untergebrachten Gegenstände wirkungsvoll gegen elektromagnetische oder Radiofrequenz-Störeinflüsse ab. Die Oberflächenbeschichtung, die daneben einer Beschädigung des oder der Gegenstände aufgrund elektrostatischer Ladungen vorbeugt, und die mit der Folie in einer elektrisch leitfähigen Verbindung steht, beseitigt die Gefahr einer Kondensatorwirkung der Folie und die damit verbundenen Gefahren für die Gegenstände. Eventuell auf der Folie auftretende Spannungen oder dort verharrende Ladungen werden überraschend über Oberflächenbeschichtung abgeleitet oder aufgezehrt. Mit anderen Worten schirmt die Folie den Gegenstand wirksam gegen Störeinflüsse hochfrequenter Felder ab. Diese Störeinflüsse, von denen jedoch Spannungen oder Ströme auf der Folie resultieren können, wenn der Gegenstand mit dem Behälter in einem Hochfrequenz-Feld bewegt wird, werden durch die Oberflächenbeschichtung beseitigt. Die Folie schützt den Gegenstand oder die Gegenstände auch gegen elektrische Überbelastungen bei Vorliegen eines in statischem Zustand präsenten hochfrequenten Feldes. Da die innen- und außenseitigen Oberflächenbeschichtungen miteinander gekoppelt sind, wird dauerhaft die Gefahr einer für den Gegenstand oder die Gegenstände schädlichen elektrischen Entladung, unabhängig von wo sie herrühren könnte, beseitigt. Diese Behälter sind vordringlich zum Lagern, Transportieren und beim Bearbeiten elektronischer Bauteile oder Schaltungen geeignet. Auch für gegen elektrische Einflüsse empfindliche Linsen, hochwertige Kunststoff- oder Metallteile, medizinische Geräte, Pharmazeutika oder dgl. sind sie ggfs. anwendbar.

Zweckmäßige Ausführungsformen des Erfindungsgegenstandes gehen aus den Unteransprüchen hervor.

In besonders zweckmäßiger Weise betreffen die Ansprüche 11 und 12 Verfahren zum Herstellen eines allseits geschlossenen Behälters als Fangfalle für elektrostatische Aufladung und für Interferenzen aufgrund hochfrequenter Felder.

Anhand der Zeichnungen werden Ausführungsformen solcher Behälter sowie Verfahren zu deren Herstellung erläutert. Es zeigen:

Fig. 1 eine perspektivische Ansicht eines erfindungsgemäß aufgebauten, eine mögliche Ausführungsform darstellenden Behälters,

Fig. 2 eine Draufsicht auf einen Wellpappe-Zuschnitt, aus dem sich der in Fig. 1 gezeigte Behälter formen läßt.

Fig. 3 eine schematische Ansicht einer Vorrichtung zum Herstellen einer Wellpappebahn, aus der solche Behälter gebildet werden können,

Fig. 4 eine Schnittansicht der Wellpappebahn von Fig. 3, in einem vergrößerten Maßstab,

Fig. 5 eine Perspektivansicht einer weiteren Ausführungsform eines Behälters, der durch einen nicht gezeigten abschirmenden Deckel oder durch einen aufgesetzten weiteren Behälter verschließbar ist,

Fig. 6 eine Schnittansicht in der Ebene 6–6 von Fig. 5, in vergrößertem Maßstab, und

Fig. 7 einen vergrößert dargestellten Ausschnitt aus Fig. 6.

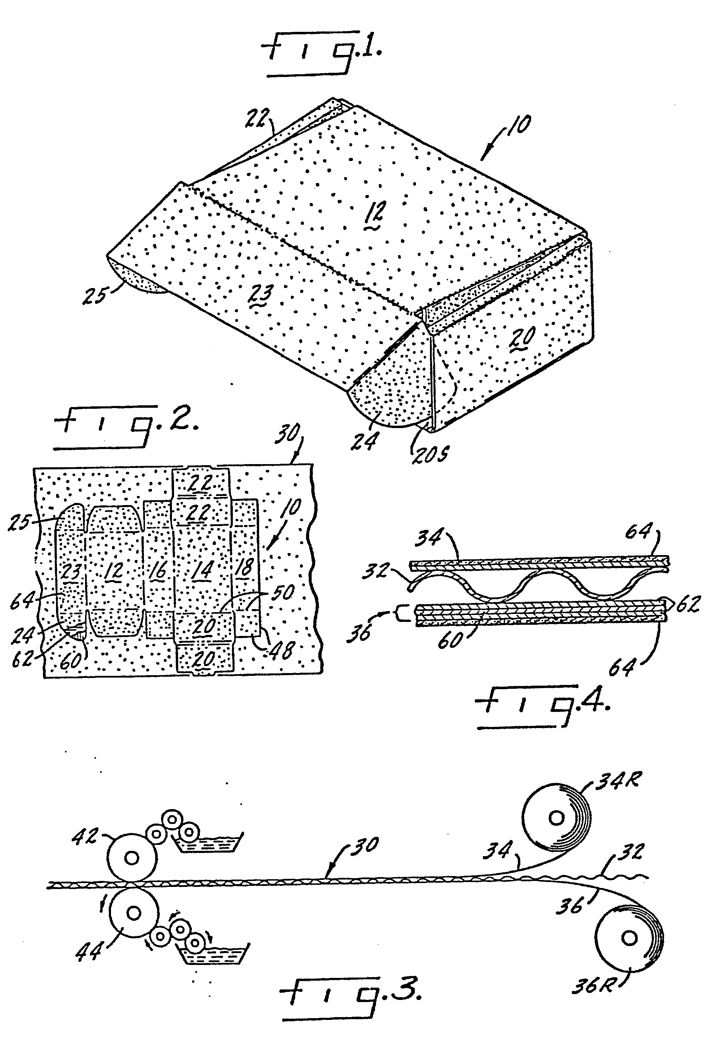

Ein einen Aufnahmeraum begrenzender, gefalteter Behälter 10 gemäß Fig. 1 und 2 hat sechs Seiten, definiert durch eine Deckwand 12, eine Bodenwand 14, Endwände 16 und 18, Seitenwände 20 und 22 (in doppelter Dicke und gefaltet) und eine Schließklappe 23 mit einsteckbaren Ohren 24 und 25.

Der Behälter 10 ist in dieser Form nur zum besseren Verständnis dargestellt. Für die praktische Verwendung unterscheiden sich die jeweils eingesetzten Behälter erheblich in ihren Dimensionen, die davon abhängen, welche elektronischen Gegenstände eingekapselt und durch die später erläuterte kohlenstoffbeschichtete Umhüllung zu schützen sind. Gezeigt wird der Behälter 10 aus einer Wellpappe des E-Wellungs-Typs (E-flute), weil diese Wellpappe leicht herzustellen ist und exzellente physikalische Festigkeitseigenschaften hat. Für stärkere Behälter 10 können auch Wellpappen des B- oder C-Wellungstypes (B-flute, C-flute) und doppelwandige Dicken verwendet werden. Jedoch könnte der Behälter auch aus sogenanntem Span-Preß-Karton einer ausreichenden Festigkeit hergestellt werden. Denkbar ist auch die Verwendung einer ausreichenden Anzahl von Papierlaminaten bestimmter Dicken, z.B. doppelwandiger Ausführung. Bei allen verwendeten Materialien ist es nur erforderlich, daß eine metallische Abschirmung zum Schützen des Gegenstandes gegen elektromagnetische oder Radiofrequenz-Interferenzen und eine Schicht leitfähigen Kohlenstoffs, nämlich Druckerschwärze oder Ruß (oder ein gleichwertiger in Teilchenform erhältlicher Leiter) die Gegenstände gegen eine Entladung statischer Elektrizität schützt und dabei in einem wirksamen Kontakt mit der metallischen Auskleidung bzw. der metallischen Abschirmung steht, wie später erläutert wird.

Unter Bezugnahme auf Fig. 3 ist erkennbar, daß eine Wellpappebahn 30 in üblicher Weise aus einer gewellten Kartonkernschicht 32 und an deren beiden Seiten angebrachter, gegenüberliegender Deckschichten 34 und 36 gebildet wird. Die Schichten sind auf übliche Weise miteinander verklebt. Die Deckschichten 34 und 36 werden von großen Walzen 34R und 36R abgezogen.

Die gegenüberliegenden, ebenen Oberflächen der beiden Deckschichten 34 und 36 sind mit leitfähigem Kohlenstoff beschichtet, der in einem passenden Lösungsmittel oder Lack dispergiert ist, beispielsweise wie dies mit Drucktinte oder Druckerschwärze möglich ist. Die den Kohlenstoff enthaltende Dispersion kann durch gegenüberliegende Walzen 42 und 44 aufgetragen werden. Die Beschichtung 64, z.B. eine Emulsion aus Ruß und dem passenden Transportmedium, z.B. einem Drucklack oder einer Drucktinte, kann alternativ auf die Deckschichten 34 und 36 auch schon aufgebracht werden, bevor die Deckschichten in Form von Rollen aufgewunden und zum Herstellungsort der Wellpappe gebracht werden. D.h., die Deckschichtmaterialien können mit der leitfähigen Beschichtung bereits versehen werden, bevor sie an der gewellten Kernschicht 32 angehaftet werden, was im Gegensatz zum in Fig. 3 gezeigten Verfahrensgang steht, bei dem die Deckschichten mit der Kernschicht verbunden werden, ehe der Auftrag der leitfähigen Beschichtung erfolgt. Die jeweils gewählte Vorgangsweise richtet sich nach ökonomischen Gesichtspunkten und den jeweils vorliegenden Herstellungs-Gegebenheiten.

Beispielsweise sind bevorzugte leitfähige Partikel, wie sie sich in der vorerwähnten Weise verarbeiten lassen, unter der Handelsbezeichnung Vulcan XC-72 LR (leitfähiger Ruß) von der Firma Cabot Corp., im Handel erhältlich. Die Charakteristika dieses Materials sind 98,5 Gew.-% fixierter Kohlenstoff (1,5% flüchtige Bestandteile) bei einer mittleren Korngröße von 19 Millimikron und einem Eich-Volumen-Widerstand (ohm-cm) im Bereich von annähernd 2,3–6.

Die Pappebahn bildet das Ausgangsmaterial zur Herstellung von Behälter-Zuschnitten der in Fig. 2 gezeigten, beispielsweisen Form. Der Zuschnitt wird entlang einem zusammenhängenden Umfangsbereich 48 mit einer Schließklappe 23 gestanzt oder geschnitten und entlang von Falzen 50 gekerbt oder eingeschnitten. Sobald dann der Zuschnitt von der Bahn getrennt worden ist, läßt er sich entweder in flachem Zustand stapeln oder falten und in gefaltetem Zustand zum Verbraucher transportieren. Die jeweils gewählte Vorgangsweise hängt von Erfordernissen und Gegebenheiten der Herstellung, des Transports und des Einsatzes ab.

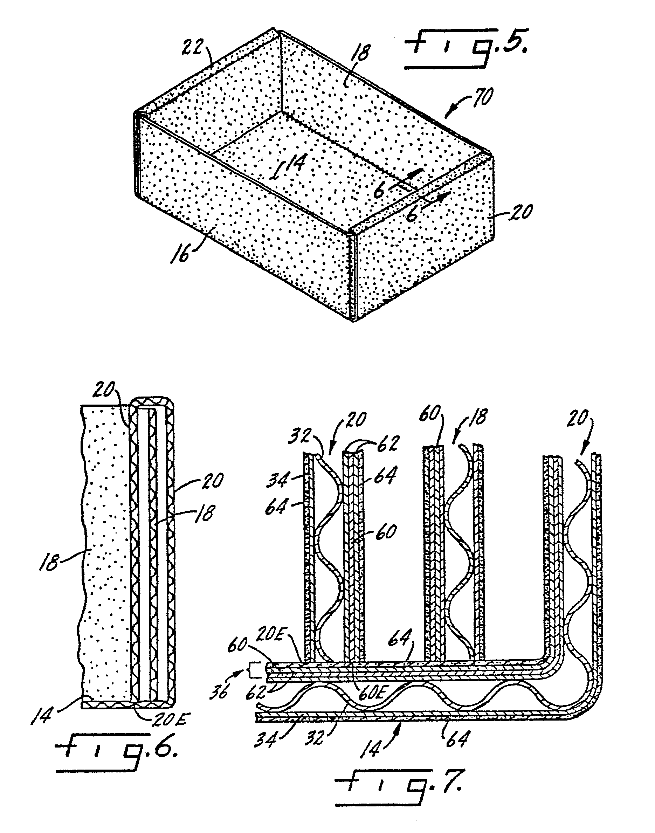

Eine der Deckschichten 34 und 36 (oder beide, wenn dieser Aufwand zwecks einer erhöhten Sicherheit getrieben werden soll) wird als Träger für eine Metallfolie 60 benutzt. Im Detail ist dies in vergrößertem Maßstab in Fig. 4 erkennbar, wobei die gezeigten Dimensionen den tatsächlichen Gegebenheiten nicht zu entsprechen brauchen. Gemäß Fig. 4 wird angenommen, daß die Deckschicht 36 als Träger für die Metallfolie 60 benutzt wird. Aus diesem Grund wurde, z.B. schon bei der Herstellung der Deckschicht 36, die Metallfolie 60 zwischen dünne Deckschichtlagen 62 eingeklebt oder auf andere Weise eingehaftet. Die dann nach außen weisende Deckschichtlage 62 (Papier) bietet die Oberfläche dar, die mit der Oberflächenbeschichtung 64 durch eine Walze 44 beschichtet wird. Jedoch ist es auch möglich, die Deckschicht 36 mit der Beschichtung 64 schon vor der Verarbeitung fertigzustellen und in Rollenform zu bringen, so daß sie anstelle der Rolle 36R in Fig. 3 verarbeitet werden kann. Aus diesem Grund ist Fig. 4 nur ein Teil eines Längsschnittes der Bahn 30, unabhängig davon, ob diese in der in Fig. 3 angedeuteten oder auf eine andere Weise hergestellt worden ist. Auf jeden Fall ist, nachdem der Zuschnitt gemäß Fig. 2 ausgestanzt oder ausgeschnitten und gefalzt worden ist, dieser dadurch gekennzeichnet, daß eine durchgehende leitfähige Oberflächenbeschichtung 64 und eine Metallfolie 60 vorliegen, die in einer zusammenhängenden Fläche dazwischengefügt ist. (Sandwich-Bauweise).

Die Metallfolie 60 kann eine Dicke von mehr oder weniger als einem Zehntausendstel Zoll (0,00254 mm) haben. Aluminium als Material für die Metallfolie wird bevorzugt. Anstelle von Aluminiumfolien können jedoch auch Eisenfolien oder andere handelsübliche Metallfolien als Substitut dienen. Die Deckschichtlage bzw. der Papierträger 62 ist ebenfalls sehr dünn, und zwar tatsächlich ausreichend dünn, um sicherzustellen, daß bei hoher Feuchtigkeit ein wirksamer leitfähiger Kontakt zwischen der Metallfolie 60 und der Oberflächenbeschichtung 64 eintritt, die notwendigerweise die Deckschichtlage imprägniert und ein bestimmtes Maß in diese eindringt.

Wie erwähnt, kann der gefaltete Behälter nahezu jede geometrische Form haben. Dabei kann überall die gleiche Wandstärke gewählt, werden, wie dies in den eingangs erwähnten Patenten gezeigt ist, oder auch in manchen Bereichen eine doppelte Wandstärke vorliegen, insbesondere in den Seitenwänden, wie dies bei den hier gezeigten Ausführungsformen der Fall ist.

Eine in Fig. 1 und 2 angedeutete Punktierung zeigt die Oberflächen des Behälters, die eine zusammenhängende Oberflächenbeschichtung tragen.

Es ist ein elektrisch-leitfähiger Kontakt zwischen der Beschichtung auf den Innenseiten und der Beschichtung auf der Außenseite des Behälters vorgesehen. Dies kann dadurch bewerkstelligt sein, daß entweder doppelwandige Faltungen oder Ohren an der Schließklappe 23 vorgesehen sind, wobei die Beschichtung an wenigstens einer inneren Oberfläche mit der Beschichtung in Kontakt steht, die sich bis zur Außenoberfläche des gefalteten Behälters erstreckt. Beispielsweise wird, sobald die Einsteckohren 24 und 25 in Faltschlitze 20S (Fig. 1) der Seitenwände eingesteckt sind, ein Kontakt zwischen vier leitfähigen Oberflächenbeschichtungen geschaffen, durch den eine allseits umhüllende Fangfalle für statische Elektrizität mit einem Continuum von der Innenseite bis zur Außenseite des Behälters entsteht, so daß jede statische Entladung entweder von der Innenseite oder von der Außenseite des Behälters zur Erde abgeleitet wird.

Die Metall-Folienabschirmung schützt den im Behälter untergebrachten Gegenstand gegen elektromagnetische und Radiofrequenz-Interferenzen. Diese Interferenzen sind Felder, die in der Lage wären, eine Spannung zu induzieren, sobald die Gegenstände im Behälter in das Feld bewegt werden. Die Abschirmung schützt ferner die Gegenstände gegen elektrische Überbelastung durch die ständige Präsenz des Feldes in einem statischen Zustand, unabhängig von jeder induzierten Spannung. Jedoch ist die Abschirmung selbst ein Leiter, der in der Lage wäre, eine induzierte Spannung zu tragen. Diese Spannung, sobald sie aufgebaut wird, wird jedoch durch die leitfähige Oberflächenbeschichtung an der Außenseite abgeleitet, die in wirksamen Kontakt mit der Beschichtung auf der inneren Seite steht. Deshalb besteht keine Möglichkeit, daß eine elektrostatische Entladung, gleich von welcher Quelle, die im Behälter untergebrachten Gegenstände erreicht, die elektrisch überbelastet oder beschädigt würden, selbst wenn nur niedrige Spannungen von 5–10 Volt oder noch weniger sie erreichen.

Es gibt dabei zwei Möglichkeiten zum Ableiten der Spannung oder der Ladung. Zunächst wird, da die Papierschichten 62 sehr dünn sind, an einigen Punkten, zumindest an einem Punkt, die Rußbeschichtung im wirksamen Kontakt mit der Metallfolie stehen, insbesondere dann, wenn eine hohe Feuchtigkeit vorliegt, die das Papier der Deckschichtlage 62 selbst zu einem Leiter macht. Wichtiger ist jedoch, daß beim Falten des Behälters wenigstens eine oder mehrere Falten einen freien Rand der Metallfolie in direkten Kontakt mit einer rußbeschichteten Fläche bringen, wie dies in Verbindung mit den Fig. 5–7 erläutert wird.

Ein Behälter 70 gemäß Fig. 5 ist ein fünfwandiger Teilespeicher oder Speicherbehälter für elektronische Teile. Bei der Benutzung des Behälters 70 wird entweder ein auf gleiche Weise abschirmender Deckel (nicht gezeigt) verwendet, oder werden mehrere Behälter 70 aufeinandergestapelt. Denkbar sind auch Behälter, die eine kleine, offene Zugangsöffnung haben.

Der Behälter 70 wird auf die gleiche Weise gebildet, wie diese anhand der Fig. 2 und 3 erläutert wurde. Unterschiedlich ist nur, daß dann, wenn der Pappezuschnitt ausgeschnitten und gefalzt wird, keine Deckwand 12, keine Verschlußklappe 23 und auch keine Einsteckohren 24 und 25 gebildet werden. Bestandteile des Behälters 70, die denen des Behälters 10 von Fig. 1 entsprechen, wurden mit denselben Bezugszeichen benannt.

Gemäß den Fig. 6 und 7 ist die Seitenwand 20 durch eine umgefaltete Klappe verstärkt. Dabei steht eine freie Schnittkante 20E der Klappe in direktem Kontakt mit der inneren Fläche der Bodenwand 14. D.h., eine Schnittkante 60E der Metallfolie 60 steht im wirksamen elektrischen Kontakt mit der Oberflächenbeschichtung 64 auf der Innenseite des Behälters, wobei dieser Kontakt sicherstellt, daß jede Ladung oder Spannung, die auf oder in der Metallfolie induziert worden ist, auf die Beschichtung 64 abgeleitet und von dieser zur Außenoberfläche des Behälters 70 abgeleitet wird, von wo sie direkt zur Erde gelangen kann. Die Seitenwand 18 gemäß Fig. 7 enthält ebenfalls eine Schnittkante der eingebrachten Metallfolie, die an der Beschichtung 64 mit direktem Kontakt ansteht.

Da der Wellpappezuschnitt ausgeschnitten oder ausgestanzt ist und die Oberflächenbeschichtungen 64 kontinuierlich sind, und da die eingesetzte Metallfolie 60 durchgehend ist, muß an den Schnittkanten der Rand der Metallfolie freiliegen. Deshalb sind die Voraussetzungen, die in Verbindung mit der Trogform des Behälters 70 der Fig. 5–7 erläutert wurden, aufgrund derer die Schnittkanten der Metallfolie 60 wirksam für das Ableiten jeder auf die Folie aufgebrachten Ladung sorgen, in gleicher Weise bei der Behälterform gemäß Fig. 1 gegeben. Es ist daher gut vorstellbar, daß bei Fig. 1, sobald die Einsteckohren 24 und 25 in die entsprechenden Schlitze 20S eingesteckt worden sind, die Schnittkanten der Metallfolie an den freiliegenden Rändern der Einsteckohren 24 und 25 in wirksamen Kontakt mit den leitfähigen Beschichtungen an der Innenoberfläche des Behälters 10 treten. Das gleiche geschieht auch bei der Seitenwand 18 und den Überfaltungen der Seitenwände 20 und 22 gemäß Fig. 1.

Die leitfähigen Ruß- oder Kohlenstoffpartikel enthaltende Oberflächenbeschichtung 64 ist vorteilhafterweise mit einer Schutzschicht, z.B. einer Versiegelung, ausgerüstet. Diese Schutzschicht liegt zumindest an den Innenflächen des Behälters vor. Zweckmäßigerweise sind aber die Innen- und die Außenfläche des Behälters mit einer solchen Schutzschicht ausgerüstet. Aufgabe der Schutzschicht ist es, die Abriebfestigkeit zu erhöhen und chemische Reaktionen zwischen dem zu schützenden Gegenstand oder seiner Verpackung und der Oberflächenbeschichtung 64 zu verhindern. Die Schutzschicht kann bereits nach dem Auftragen der Oberflächenbeschichtung 64 aufgebracht werden, d.h., vor oder bei der Herstellung der Wellpappebahn. Denkbar ist es allerdings auch, die Innenflächen des Aufnahmeraums erst nachträglich, gegebenenfalls bei gefaltetem Behälter, zu versiegeln.

**Patentansprüche**

1. Behälter, insbesondere Faltbehälter (10, 70), aus Wellpappe oder ähnlich steifem Pappmaterial, die bzw. das wenigstens einseitig eine zusammenhängende, Kohlenstoff enthaltende Oberflächenbeschichtung (64) aufweist, mit wenigstens einem nach Art eines Faraday'schen Käfigs abgeschirmten Aufnahmeraum zum Unterbringen eines gegen elektrische Einflüsse empfindlichen Gegenstandes, wobei die Oberflächenbeschichtung sich im Aufnahmeraum an dessen dem Gegenstand zugewandten Innenseiten befindet, dadurch gekennzeichnet, daß die Wellpappe bzw. das Pappmaterial (30) zusätzlich wenigstens eine zusammenhängende Schicht einer metallischen, elektrisch-leitfähigen Folie (60) enthält, die mit der Oberflächenbeschichtung (64) in elektrischleitfähiger Verbindung steht.

2. Behälter nach Anspruch 1, wobei die Wellpappe oder das Pappmaterial wenigstens eine innere Deckschicht (36) aufweist, dadurch gekennzeichnet, daß die Folie (60) in die Deckschicht (36) eingegliedert und von der Oberflächenbeschichtung (64) durch wenigstens eine Deckschichtlage (62) getrennt ist.

3. Behälter nach Anspruch 2, dadurch gekennzeichnet, daß die Folie (60) zwischen zwei Deckschichtlagen (62) einkaschiert ist.

4. Behälter nach einem der Ansprüche 1 bis 3, wobei die Wellpappe (30) aus einer Kernschicht (32) aus gewellter Pappe und beidseitigen, mit der Kernschicht (32) verbundenen Deckschichten (34, 36) besteht, dadurch gekennzeichnet, daß beide Deckschichten (34, 36) außenseitig eine Oberflächenbeschichtung (64) mit Kohlenstoffpartikeln tragen.

5. Behälter nach einem der Ansprüche 1, 2 und 4, dadurch gekennzeichnet, daß die Folie (60) auf eine Deckschichtlage (62) aufgedampft ist.

6. Behälter nach einem der Ansprüche 1 bis 5, dadurch gekennzeichnet, daß die Folie (60) und die Oberflächenbeschichtung (64) direkt, im Falle der Ansprüche 2 bis 5 vorzugsweise zumindest punktweise durch die sie trennende Deckschichtlage (62) hindurch, in elektrisch leitfähiger Verbindung stehen.

7. Behälter nach einem der Ansprüche 1 bis 6, dadurch gekennzeichnet, daß die Folie (60) mit der Oberflächenbeschichtung (64) dadurch elektrisch leitfähig verbunden ist, daß eine freie Schnittkante (60E) der Folie (60) an der Oberflächenbeschichtung (64) eines in etwa senkrecht dazu verlaufenden Behälterteils berührend anliegt.

8. Behälter nach einem der Ansprüche 1 bis 7, wobei der Behälter (10) aus mindestens einem ausgeschnittenen oder ausgestanzten Behälterzuschnitt aus Wellpappe oder Pappmaterial (30) durch Falten gebildet ist, dadurch gekennzeichnet, daß der Behälter (10) sechs an beiden Seiten mit einer Oberflächenbeschichtung (64) versehene Begrenzungswände (12, 14, 16, 18, 20, 22) aufweist, und daß die inneren und äußeren Oberflächenbeschichtungen miteinander elektrisch-leitfähig verbunden sind, und daß eine freie Schnittkante (60E) der Folie (60) auf der Oberflächenbeschichtung (64), vorzugsweise stumpf, aufsteht.

9. Behälter nach Anspruch 8, dadurch gekennzeichnet, daß der Behälter (10) eine an beiden Seiten mit einer Oberflächenbeschichtung (64) versehene Schließklappe (23) aufweist, die im Behälter mit ihrer Außenseite an einer Innenseite anliegt.

10. Behälter nach einem der Ansprüche 1 bis 9, dadurch gekennzeichnet, daß zumindest die an der Innenseite des Behälters angeordnete Oberflächenbeschichtung (64) mit einer Schutzschicht, vorzugsweise einer Versiegelung, gegen Abrieb und chemische Reaktionen zwischen der Oberflächenbeschichtung (64) und dem zu schützenden Gegenstand ausgerüstet ist.

11. Verfahren zum Herstellen eines allseits geschlossenen Behälters als Fangfalle (4) für von außerhalb oder von innerhalb stammende statische Elektrizität und zum Aufzehren bzw. Ableiten induzierter Spannung bzw. induzierten Stroms, um wenigstens einen für elektrische Einflüsse empfindlichen Gegenstand zu schützen, gekennzeichnet durch folgende Schritte:

a) die gegenüberliegenden ebenen Oberflächen einer Wellpappe- oder Pappmaterialbahn, die wenigstens eine Metallfolie enthält, werden mit einer leitfähigen, Kohlenstoff enthaltenden Dispersion beschichtet,

b) die Folie wird zumindest punktweise mit der Oberflächenbeschichtung elektrisch-leitfähig verbunden,

c) aus der Bahn wird ein zum Falten gefalzter Behälterzuschnitt mit wenigstens einer einstückigen Klappe ausgeschnitten,

d) der Behälterzuschnitt wird zu einem verschließbaren Behälter gefaltet,

e) in den Behälter wird vor seinem Verschließen der zu schützende Gegenstand eingebracht, beim Falten oder Verschließen wird die innenseitige Oberflächenbeschichtung mit der außenseitigen in Kontakt gebracht.

12. Verfahren zum Herstellen eines allseits geschlossenen Behälters als Fangfalle (4) für von außerhalb oder von innerhalb stammende statische Elektrizität und zum Aufzehren bzw. Ableiten induzierter Spannung bzw. induzierten Stroms, um wenigstens einen für elektrische Einflüsse empfindlichen Gegenstand zu schützen, gekennzeichnet durch folgende Schritte:

a) die gegenüberliegenden ebenen Oberflächen einer Wellpappe- oder Pappmaterialbahn, die wenigstens eine Metallfolie enthält, werden mit einer leitfähigen, Kohlenstoff enthaltenden Dispersion beschichtet,

b) aus der Bahn wird ein zum Falten gefalzter Behälterzuschnitt mit wenigstens einer einstückigen Klappe ausgeschnitten, wobei freie Schnittkanten der Metallfolie gebildet werden,

c) der Behälterzuschnitt wird zu einem verschließbaren Behälter gefaltet,

d) in den Behälter wird vor seinem Verschließen der zu schützende Gegenstand eingebracht, beim Falten oder Verschließen werden die innenseitige Oberflächenbeschichtung mit der außenseitigen und wenigstens eine freie Schnittkante der Metallfolie, z.B. in der Klappe, mit einer Oberflächenbeschichtung in Kontakt gebracht.

## Claims

1. Container, in particular folding container (10, 70), made of corrugated cardboard or similarly stiff cardboard material which has at least on one side a continuous carbon-containing surface coating (64), having at least one storage space shielded in the manner of a Faraday cage for accommodating an object sensitive to electrical influence, the surface coating being located in the storage space on the inner sides facing the object, characterized in that the corrugated cardboard or the cardboard material (30) additionally contains at least one continuous layer of a metallic, electrically conductive foil (60) which is connected in electrically conductive manner to the surface coating (64).

2. Container according to Claim 1, the corrugated cardboard or the cardboard material having at least one inner top layer (36), characterized in that the foil (60) is incorporated in the top layer (36) and is separated from the surface coating (64) by at least one top layer ply (62).

3. Container according to Claim 2, characterized in that the foil (69) is laminated between two top layer plies (62).

4. Container according to one of Claims 1 to 3, the corrugated cardboard (30) consisting of a core layer (32) made of corrugated cardboard and top layers (34, 36), connected to the core layer (32), on both sides, characterized in that both top layers (34, 36) have on their outer side a surface coating (64) with carbon particles.

5. Container according to one of Claims 1, 2 and 4, characterized in that the foil (60) is evaporated onto one top layer ply (62).

6. Container according to one of Claims 1 to 5, characterized in that the foil (60) and the surface coating (64) are directly connected in electrically conductive manner, in the case of Claims 2 to 5 preferably at least in spot fashion through the top layer ply (62) which separates them.

7. Container according to one of Claims 1 to 6, characterized in that the foil (60) is connected in electrically conductive manner to the surface coating (64) in that a free cut edge (60E) of the foil (60) lies against and in contact with the surface coating (64) of a container part extending approximately perpendicularly thereto.

8. Container according to one of Claims 1 to 7, the container (10) being formed from at least one cut out or punched out container blank made of corrugated cardboard or cardboard material (30) by means of folding, characterized in that the container (10) has six delimiting walls (12, 14, 16, 18, 20, 22) provided on both sides with a surface coating (64), and in that the inner and outer surface coatings are connected to one another in electrically conductive manner, and in that a free cut edge (60E) of the foil (60) stands up on the surface coating (64), preferably in a butt-type manner.

9. Container according to Claim 8, characterized in that the container (10) has a closing flap (23) which is provided on two sides with a surface coating (64) and which with its outer side lies against an inner side in the container.

10. Container according to one of Claims 1 to 9, characterized in that at least the surface coating (64) arranged on the inner side of the container is equipped with a protective layer, preferably a seal, against abrasion and chemical reactions between the surface coating (64) and the object to be protected.

11. Method for manufacturing a container closed in all round as a trap (4) for static electricity arising outside or inside and for absorbing or discharging induced voltage or induced current, in order to protect at least one object sensitive to electrical influences, characterized by the following steps:
   a) the opposite plane surfaces of a web of corrugated cardboard or cardboard material containing at least one metal foil are coated with a conductive, carbon-containing dispersion,
   b) the foil is connected at least in spot fashion to the surface coating in an electrically conductive manner,
   c) a container blank, creased for folding, is cut out of the web with at least one intergral flap,
   d) the container blank is folded to a closeable container,
   e) before being closed, the object to be protected is introduced into the container, the surface coating on the inner sides is brought into contact with the surface coating on the outer sides in the course of folding or closing.

12. Method for manufacturing a container closed in all round as a trap (4) for static electricity arising outside or inside and for absorbing or discharging induced voltage or induced current, in order to protect at least one object sensitive to electrical influences, characterized by the following steps:
   a) the opposite plane surfaces of the web of corrugated cardboard or cardboard material containing at least one metal foil are coated with a conductive, carbon-containing dispersion,
   b) a container blank, creased for folding, is cut out of the web with at least one integral flap, free cut edges of the metal foil being formed,
   c) the container blank is folded to a closeable container,
   d) before being closed, the object to be protected is introduced into the container, the surface coating on the inner sides is brought into contact with the surface coating on the outer sides and at least one free cut edge of the metal foil, for example in the flap, in the course of folding or closing.

## Revendications

1. Récipient, en particulier récipient pliant (10, 70), en carton ondulé ou matériau rigide analogue du type carton qui présente, au moins d'un côté, un revêtement de surface (64) cohérent contenant du carbone, récipient comportant au moins un espace de réception, blindé à la façon d'une cage de Faraday, pour y loger un objet sensible à l'égard des influences électriques, étant précisé que le revêtement de surface se trouve dans l'espace de réception, sur ses faces intérieures orientées vers l'objet, récipient, caractérisé en ce que le carton ondulé ou le matériau du type carton (30) contient en outre au moins une couche cohérente d'une feuille métallique électriquement conductrice (60) qui est en liaison électriquement conductrice avec le revêtement de surface (64).

2. Récipient selon la revendication 1, dans lequel le carton ondulé ou le matériau du type carton présente au moins une couche de couverture intérieure (36), caractérisé en ce que la feuille (60) est insérée dans la couche de couverture (36) et en ce qu'elle est séparée du revêtement de surface (64) par au moins une feuille (62) faisant partie de la couche de couverture.

3. Récipient selon la revendication 2, caractérisé en ce que la feuille (60) vient en doublage entre deux feuilles (62) faisant partie de la couche de couverture.

4. Récipient selon l'une des revendications 1 à 3, dans lequel le carton ondulé (30) est constitué d'une âme (32) de carton ondulé et de couches de couverture (34, 36) reliées des deux côtés, à l'âme (32), caractérisé en ce que les deux couches de couverture (34, 36) portent, sur leurs faces extérieures, un revêtement de surface (64) contenant des particules de carbone.

5. Récipient selon l'une des revendications 1, 2 et 4, caractérisé en ce que la feuille (60) est déposée, par métallisation sous vide, sur une feuille (62) faisant partie de la couche de couverture.

6. Récipient selon l'une des revendications 1 à 5, caractérisé en ce que la feuille (60) et le revêtement de surface (64) sont directement en liaison électriquement conductrice, dans le cas des revendications 2 à 5, de préférence au moins par points, à travers la feuille (62), faisant partie de la couche de couverture, qui les sépare.

7. Récipient selon l'une des revendications 1 à 6, caractérisé en ce que la feuille (60) est reliée, de façon électriquement conductrice, avec le revêtement de surface (74) par le moyen qu'un bord coupé libre (60E) de la feuille (60) s'appuie, avec contact, contre le revêtement de surface (64) d'une partie du récipient qui lui est à peu près perpendiculaire.

8. Récipient selon l'une des revendications 1 à 7, dans lequel le récipient (10) est formé par pliage d'au moins une coupe de récipient, en carton ondulé ou en matériau du type carton (30), obtenue par découpage ou estampage, caractérisé en ce que le récipient (10) présente six parois limites (12, 14, 16, 18, 20, 22) munies, des deux côtés, d'un revêtement de surface (64), et en ce que les revêtements de surface intérieurs et extérieurs sont réunis l'un à l'autre au point de vue conduction électrique, et en ce qu'un bord coupé libre (60E) de la feuille (60), de préférence émoussé, se dresse sur le revêtement de surface (64).

9. Récipient selon la revendication 8, caractérisé en ce que le récipient (10) présente un volet de fermeture (23) qui est muni, sur ses deux faces, d'un revêtement de surface (64) et qui, dans le récipient, s'appuie, par sa face extérieure, contre une face intérieure.

10. Récipient selon l'une des revendications 1 à 9, caractérisé en ce qu'au moins le revêtement de surface (74) disposé sur la face intérieure du récipient est muni d'une couche de protection, de préférence d'une vitrification, à l'égard de l'usure et des réactions chimiques entre le revêtement de surface (64) et l'objet à protéger.

11. Procédé de fabrication d'un récipient, fermé de tous les côtés, sous forme de piège (4) pour l'électricité statique provenant de l'extérieur ou de l'intérieur et pour épuiser et évacuer une tension induite ou un courant induit, pour protéger au moins un objet sensible aux influences électriques, caractérisé par les étapes suivantes:

a) On revêt d'une dispersion conductrice contenant du carbone les surfaces planes, situées l'une en face de l'autre, d'une bande de carton ondulé ou de matériau du type carton qui contient au moins une feuille de métal.

b) On réunit, au point de vue conduction électrique, la feuille, au moins par points, au revêtement de surface.

c) Dans la bande, on découpe une coupe de récipient, striée à l'endroit du pliage et présentant au moins un volet solidaire.

d) On plie la coupe pour devenir un récipient pouvant se fermer.

e) Dans le récipient, et avant de le fermer, on dispose l'objet à protéger, par pliage ou fermeture, on met en contact le revêtement de surface intérieur avec le revêtement de surface extérieur.

12. Procédé de fabrication d'un récipient, fermé de tous les côtés, sous forme de piège (4) pour l'électricité statique provenant de l'extérieur ou de l'intérieur et pour épuiser et évacuer une tension induite ou un courant induit, pour protéger au moins un objet sensible aux influences électriques, caractérisé par les étapes suivantes:

a) On revêt d'une dispersion conductrice contenant du carbone les surfaces planes, situées l'une en face de l'autre, d'une bande de carton ondulé ou de matériau du type carton qui contient au moins une feuille de métal.

b) Dans la bande, on découpe une coupe de récipient, striée à l'endroit du pliage et présentant au moins un volet solidaire, de sorte qu'il se forme des bords découpés libres de la feuille de métal.

c) On plie la coupe pour devenir un récipient pouvant se fermer.

d) Dans le récipient, et avant de le fermer, on dispose l'objet à protéger, par pliage ou fermeture, on met en contact le revêtement de surface intérieur avec le revêtement de surface extérieur et au moins un bord découpé libre de la feuille de métal, par exemple dans le volet, avec un revêtement de surface.

fig.1.

fig.2.

fig.4.

fig.3.

fig.5.

fig.6.

fig.7.